# EUROPÄISCHE PATENTANMELDUNG

(11) **EP 4 757 163 A1**
(43) Veröffentlichungstag der Anmeldung: **10.06.2026**
(21) Anmeldenummer: 25219913.8
(22) Anmeldetag: 01.12.2025
(51) Int. Cl.: H02M 7/5395, H02M 7/00, H02M 1/12, H02M 1/44, H01G 4/38, H01G 4/40, H02G 5/00, H05K 7/14

(54) **VORRICHTUNG FÜR EINEN STROMWANDLER, STROMWANDLER UND FAHRZEUG**

(30) Priorität: 09.12.2024 DE 102024136779
(71) Anmelder: Volkswagen Aktiengesellschaft, 38440 Wolfsburg (DE)
(72) Erfinder: Enzinger, Tobias, 38440 Wolfsburg (DE); Sommer, Dr. Christian, 38440 Wolfsburg (DE); Olbrich, Dr. Peter, 38440 Wolfsburg (DE)

(57) **Zusammenfassung**

Die Erfindung betrifft eine Vorrichtung (100) für einen Stromwandler (200), umfassend:
- mindestens einen X-Kondensator (10),
- mindestens einen ersten Y-Kondensator (20),
- mindestens einen weiteren Y-Kondensator (30),

wobei mindestens eine erste Stromschiene (50) den mindestens einen X-Kondensator (10) und den mindestens einen ersten Y-Kondensator (20) kontaktiert, wobei mindestens eine weitere Stromschiene (60) den mindestens einen X-Kondensator (10) und den mindestens einen weiteren Y-Kondensator (30) kontaktiert, wobei die erste Stromschiene (50) den mindestens einen X-Kondensator (10) in einer ersten Kontaktebene (K1) kontaktiert, wobei die weitere Stromschiene (60) den mindestens einen X-Kondensator (10) in einer weiteren Kontaktebene (K2) kontaktiert, wobei sowohl der mindestens eine X-Kondensator (10) als auch die Y-Kondensatoren (20, 30) in einem Bauraum zwischen der ersten Kontaktebene (K1) und der weiteren Kontaktebene (K2) angeordnet sind, wobei der mindestens eine erste Y-Kondensator (20) und der mindestens eine weitere Y-Kondensator (30) gemeinsam an ein Anschlusselement (70) angeschlossen sind, wobei das Anschlusselement (70) zur Anbindung an eine Masse (M) ausgebildet ist,
sowie einen Stromwandler (200) und ein Fahrzeug (300).

## Beschreibung

Die Erfindung betrifft eine Vorrichtung für einen Stromwandler, einen Stromwandler und ein Fahrzeug.

In leistungselektronischen Schaltungen, die beispielsweise in Wechselrichtern für Elektrofahrzeuge Anwendung finden, ist eine zuverlässige Reduktion von elektrischen Störungen und eine effiziente Energienutzung entscheidend. Insbesondere parasitäre Induktivitäten beeinträchtigen die energetische Effizienz der Schaltungen.

Die US 2016 / 0 172 111 A1 betrifft ein Kondensatormodul eines Wechselrichters für ein Fahrzeug mit sogenannten DC-Link-Kondensatoren und Y-Kondensatoren. Hieraus ist bekannt, dass elektrische Störungen, insbesondere Gleichtaktstörungen, durch die Verschaltung der DC-Link-Kondensatoren und Y-Kondensatoren reduziert werden können.

Es stellt sich das technische Problem, eine Vorrichtung für einen Stromwandler, einen Stromwandler und ein Fahrzeug zu schaffen, welche elektrische Störungen effektiv reduzieren, parasitäre Effekte minimieren und gleichzeitig eine kompakte Bauweise ermöglichen.

Die Lösung des technischen Problems ergibt sich durch die Gegenstände mit den Merkmalen der unabhängigen Ansprüche. Weitere vorteilhafte Ausgestaltungen der Erfindung ergeben sich aus den Unteransprüchen.

Vorgeschlagen wird eine Vorrichtung für einen Stromwandler, umfassend:
- mindestens einen X-Kondensator,
- mindestens einen ersten Y-Kondensator,
- mindestens einen weiteren Y-Kondensator,
wobei mindestens eine erste Stromschiene den mindestens einen X-Kondensator und den mindestens einen ersten Y-Kondensator kontaktiert, wobei mindestens eine weitere Stromschiene den mindestens einen X-Kondensator und den mindestens einen weiteren Y-Kondensator kontaktiert, wobei die erste Stromschiene den mindestens einen X-Kondensator in einer ersten Kontaktebene kontaktiert, wobei die weitere Stromschiene den mindestens einen X-Kondensator in einer weiteren Kontaktebene kontaktiert, wobei sowohl der mindestens eine X-Kondensator als auch die Y-Kondensatoren in einem Bauraum zwischen der ersten Kontaktebene und der weiteren Kontaktebene angeordnet sind, wobei der mindestens eine erste Y-Kondensator und der mindestens eine weitere Y-Kondensator gemeinsam an ein Anschlusselement angeschlossen sind, wobei das Anschlusselement zur Anbindung an eine Masse ausgebildet ist.

Die Vorrichtung hat zum Vorteil, dass elektrische Störungen und parasitäre Effekte - die z.B. in einem Stromwandler auftreten können - in kompakter Bauweise reduziert werden können. Dies wird technisch bewirkt, indem sowohl der X-Kondensator als auch die Y-Kondensatoren in dem Bauraum zwischen den Kontaktebenen angeordnet sind.

Weiter vorgeschlagen wird ein Stromwandler, umfassend mindestens eine Vorrichtung nach einer in dieser Offenbarung beschriebenen Ausführungsform. Der Stromwandler kann z.B. als ein Wechselrichter, insbesondere als ein Pulswechselrichter, ausgebildet sein. Der Stromwandler kann mehrere Wandlungsstufen umfassen, wie z.B. eine Wechselrichterstufe, insbesondere einen Pulswechselrichter, und eine Gleichrichterstufe, insbesondere einen 12-Volt Gleichrichter. Der Stromwandler ist insbesondere zur Verwendung in einem Fahrzeug ausgebildet. Der Stromwandler kann z.B. zwischen einer Traktionsbatterie des Fahrzeugs und einem Elektromotor des Fahrzeugs angeordnet sein. Die Stromschienen der Vorrichtung können an ein Leistungsmodul des Stromwandlers angeschlossen sein. Die Vorrichtung kann daher auch als Zwischenkreiskondensatormodul bezeichnet werden. Das Anschlusselement der Vorrichtung kann insbesondere an eine Masse des mindestens einen Leistungsmoduls angebunden sein.

Ferner wird ein Fahrzeug vorgeschlagen, umfassend mindestens eine Vorrichtung und/oder mindestens einen Stromwandler gemäß einer in dieser Offenbarung beschriebenen Ausführungsform. Das Fahrzeug kann z.B. als ein PKW, LKW, Luftfahrzeug oder Wasserfahrzug ausgebildet sein. Der im Fahrzeug zur Verfügung stehende Bauraum kann aufgrund der kompakten Bauweise der Vorrichtung besser genutzt werden. Das Fahrzeug kann zumindest teilweise elektrisch betrieben sein. Das Fahrzeug kann insbesondere eine höhere Reichweite erzielen, da aufgrund der reduzierten elektrischen Störungen z.B. Schaltzeiten von Leistungshalbleitern des Stromwandlers verbessert werden und somit elektrische Verluste bei der Stromwandlung minimiert werden können.

Die im Rahmen dieser Offenbarung für die Vorrichtung erläuterten technischen Effekte und Vorteile treffen selbstverständlich auch für den Stromwandler und das Fahrzeug zu und umgekehrt.

Der X-Kondensator kann z.B. ein Wickelkondensator sein. Der X-Kondensator kann auch als DC-Link-Kondensator oder Zwischenkreiskondensator bezeichnet werden. Der X-Kondensator kann an einer ersten Seite, z.B. an einer Unterseite, einen Elektrodenanschluss aufweisen. Die erste Seite kann z.B. zum Anschluss des X-Kondensators an die erste Stromschiene dienen. Der X-Kondensator kann an einer weiteren Seite, insbesondere an einer der ersten Seite gegenüberliegenden Seite, wie z.B. an einer Oberseite, einen weiteren Elektrodenanschluss aufweisen. Die weitere kann z.B. zum Anschluss des X-Kondensators an die weitere Stromschiene dienen. Die Vorrichtung kann selbstverständlich eine Mehrzahl von X-Kondensatoren aufweisen, die z.B. mittels der Stromschienen parallelgeschaltet sind. Die Mehrzahl von X-Kondensatoren ist insbesondere in dem Bauraum zwischen den Kontaktebenen angeordnet.

Die erste Kontaktebene wird z.B. durch die erste Seite des X-Kondensators aufgespannt. Die weitere Kontaktebene wird z.B. durch die weitere Seite des X-Kondensators aufgespannt. Die Kontaktebenen sind insbesondere parallel zueinander orientiert. Die Kontaktebenen sind z.B. um eine Bauhöhe des X-Kondensators voneinander beabstandet.

Die Y-Kondensatoren können z.B. ebenfalls Wickelkondensatoren sein. Die Y-Kondensatoren können eine geringere Größe, insbesondere eine geringere Bauhöhe und/oder eine geringere Kapazität, als der X-Kondensator aufweisen, da die Y-Kondensatoren der Filterung von hochfrequenten Störungen wie z.B. Oberschwingungen dienen und daher kleiner ausgelegt sein können. Die Y-Kondensator können ebenfalls jeweils eine Ober- und eine Unterseite mit einem Elektrodenanschluss aufweisen. Daher kann eine der Seiten des ersten Y-Kondensators zum Anschluss an die erste Stromschiene dienen und eine der Seiten des weiteren Y-Kondensators zum Anschluss an die weitere Stromschiene dienen. Der erste Y-Kondensator ist insbesondere baugleich zu dem weiteren Y-Kondensator. Selberverständlich kann die Vorrichtung eine Mehrzahl erster Y-Kondensatoren und/oder eine Mehrzahl weiterer Y-Kondensatoren aufweisen. Die Mehrzahl von ersten Y-Kondensatoren und/oder weiteren Y-Kondensatoren kann in dem Bauraum zwischen den Kontaktebenen angeordnet sein.

Die Stromschienen können aus Kupfer hergestellt sein. Die erste Stromschiene kann z.B. eingangsseitig an einen Minuspol der Traktionsbatterie des Fahrzeugs angeschlossen sein. Die erste Stromschiene kann ein niedriges elektrisches Potential aufweisen. Die weitere Stromschiene kann z.B. eingangsseitig an einen Pluspol der Traktionsbatterie angeschlossen sein. Die weitere Stromschiene kann ein höheres elektrisches Potential als die erste Stromschiene aufweisen. Die Stromschienen können z.B. ausgangsseitig an einen jeweiligen Anschluss des Leistungsmoduls angeschlossen sein.

Das Anschlusselement kann ebenfalls aus Kupfer hergestellt sein. Das Anschlusselement kann die Y-Kondensatoren z.B. an den verbleibenden Seiten der Y-Kondensatoren kontaktieren. Das Anschlusselement kann z.B. als sogenanntes Z-Blech ausgebildet sein. Ein freies Ende oder mindestens eine erste Seite des Anschlusselements kann zum Kontaktieren der Y-Kondensatoren ausgebildet sein. Ein weiteres freies Ende des Anschlusselement oder zumindest eine weitere Seite kann zum Anbinden der Y-Kondensatoren an die Masse dienen. Das Anschlusselement weist insbesondere mindestens eine Anschlussfläche zum Anbinden an die Masse auf. Die mindestens eine Anschlussfläche kann z.B. aus dem Bauraum zwischen den Kontaktebenen herausragen, sodass ein problemloses Anbinden an die Masse außerhalb des Bauraums ermöglicht ist.

Der Bauraum zwischen den Kontaktebenen kann z.B. durch eine Bauhöhe des X-Kondensators begrenzt sein. Der Bauraum kann zusätzlich durch eine Baubreite des X-Kondensators begrenzt sein. ferner kann eine Seitenwand eines Gehäuses der Vorrichtung den Bauraum begrenzen. Eine Bauhöhe und/oder Baubreite des jeweiligen Y-Kondensators ist insbesondere geringer als eine Bauhöhe und/oder Baubreite des X-Kondensators. Die Elektrodenanschlüsse des X-Kondensators bzw. des jeweiligen Y-Kondensators können zur Bauhöhe des jeweiligen Kondensators hinzugerechnet werden. Die Y-Kondensatoren können jeweils insbesondere eine Baubreite aufweisen, die weniger als 50% der Baubreite des X-Kondensators entspricht, sodass zwei Y-Kondensatoren nebeneinander in dem Bauraum angeordnet werden können.

In einer Ausführungsform sind der mindestens eine erste Y-Kondensator und der mindestens eine weitere Y-Kondensator gemeinsam in einer Stufe eines Gehäuses der Vorrichtung angeordnet. Der Bauraum zwischen den Kontaktebenen kann durch die Stufe zusätzlich begrenzt werden, was die kompakte Bauweise der Vorrichtung verbessert. Das Gehäuse kann z.B. ein Spritzguss-, Blech- oder Gussgehäuse sein. Das Gehäuse kann insbesondere ein Gehäuseteil des Stromwandlers sein. Die Kondensatoren und/oder die Stromschienen können innerhalb des Gehäuses in einer Vergussmasse vergossen sein. Die Vergussmasse kann z.B. Epoxidharz sein. Aufgrund der Stufe wird weniger Vergussmasse zum Vergießen der Y-Kondensatoren benötigt, da ein Vergussvolumen innerhalb des Gehäuses durch die Stufe verringert sein kann. Die Stufe kann eine Form aufweisen, die an eine Abmessung der Y-Kondensatoren, wie z.B. eine Bauhöhe, -breite und/oder -tiefe, angepasst ist. Die Stufe kann eine Höhe des Bauraums begrenzen. Die Stufe kann insbesondere entlang einer Seite des Gehäuses oder entlang mehrerer Seiten des Gehäuses ausgebildet sein, sodass z.B. der erste Y-Kondensator und der weitere Y-Kondensator über die gesamte Länge einer Seite oder sogar an mehreren Seiten des Gehäuses angeordnet sein können.

In einer Ausführungsform kontaktiert die erste Stromschiene den mindestens einen X-Kondensator und den mindestens einen ersten Y-Kondensator in der ersten Kontaktebene. Auf diese Weise muss die erste Stromschiene nicht gebogen werden, um den X-Kondensator und den ersten Y-Kondensator zu kontaktieren. Dies vereinfacht die Herstellung der Vorrichtung und verkürzt einen elektrischen Leiterweg zwischen dem X-Kondensator und dem ersten Y-Kondensator.

Alternativ oder kumulativ kontaktiert die weitere Stromschiene den mindestens einen X-Kondensator und den mindestens einen weiteren Y-Kondensator in der weiteren Kontaktebene. Auf diese Weise muss die weitere Stromschiene nicht gebogen werden, um den X-Kondensator und den weiteren Y-Kondensator zu kontaktieren. Dies vereinfacht die Herstellung der Vorrichtung zusätzlich und verkürzt einen elektrischen Leiterweg zwischen dem X-Kondensator und dem weiteren Y-Kondensator.

In einer Ausführungsform ist das Anschlusselement mittels mindestens einer Kontaktfeder an die Masse angebunden. Auf diese Weise kann eine werkzeugfreie und lösbare Anbindung an die Masse erfolgen. Die Anbindung an die Masse kann z.B. während der Montage erfolgen, indem das Anschlusselement über die Kontaktfeder mit einem Massepunkt in Verbindung gebracht wird. Die Kontaktfeder kann z.B. eine elektrisch leitende Spiralfeder sein. Die Kontaktfeder kann Teil der Vorrichtung sein. Beispielsweise kann die Kontaktfeder stoffschlüssig mit dem Anschlusselement verbunden sein.

In einer Ausführungsform sind der mindestens eine erste Y-Kondensator und der mindestens eine weitere Y-Kondensator in dem Bauraum übereinander angeordnet. Auf diese Weise wird eine Bauhöhe des Bauraums zwischen den Kontaktebenen effizient genutzt. Die Y-Kondensatoren können - wenn sie übereinander angeordnet sind - eine gemeinsame Bauhöhe aufweisen, die geringer als die Bauhöhe des X-Kondensators ist. Das Anschlusselement kann den ersten Y-Kondensator z.B. an der Oberseite des ersten Y-Kondensators kontaktieren und den weiteren Y-Kondensator z.B. an der Unterseite des weiteren Y-Kondensators. Mit anderen Worten: Das Anschlusselement kann zwischen den übereinander angeordneten Y-Kondensatoren angeordnet sein, um die Y-Kondensatoren in dem Bauraum zu kontaktieren.

In einer Ausführungsform umfasst das gemeinsame Anschlusselement mindestens einen elektrischen Widerstand. Auf diese Weise können hochfrequente Störungen noch effizienter gedämpft werden. Der elektrische Widerstand kann z.B. ein Dickschichtwiderstand sein. Das Anschlusselement kann einen Abschnitt aufweisen, der als PCB-Abschnitt (printed curcuit board) ausgebildet ist. In dem Abschnitt kann der elektrische Widerstand als sogenannter SMD-Widerstand (surface mounted device) angeordnet sein.

In einer Ausführungsform weist das Anschlusselement mindestens eine Anschlussfläche zur Kontaktierung der Masse auf, wobei die mindestens eine Anschlussfläche außerhalb eines Vergussvolumens der Vorrichtung angeordnet ist. Auf diese Weise kann die Anbindung an die Masse während der Montage erfolgen. Beispielsweise kann die Anschlussfläche während der Montage mit der eingangs erläuterten Kontaktfeder in Kontakt gebracht werden, um das Anschlusselement an die Masse anzubinden. Insbesondere kann die Kontaktfeder an der Anschlussfläche montiert sein. Die Anschlussfläche ermöglicht eine lösbare und werkzeugfreie Anbindung an die Masse. Alternativ kann die Anschlussfläche auch zur stoffschlüssigen Anbindung an eine Masse genutzt werden, z.B. durch Laserschweißen. Das Anschlusselement kann von der Vergussmasse umrahmt werden. Beispielsweise kann das Anschlusselement derart angeordnet sein, dass nur die Anschlussfläche aus der Vergussmasse herausragt. Mit anderen Worten: Das Anschlusselement kann in der Vergussmasse vergossen sein, ohne dass die Anschlussfläche von der Vergussmasse bedeckt wird.

In einer Ausführungsform ist die Vorrichtung symmetrisch ausgebildet. Auf diese Weise kann die elektrische Stabilität der Vorrichtung z.B. gegenüber Rückkopplungen sowie die elektromagnetische Verträglichkeit der Vorrichtung verbessert werden. Insbesondere kann eine Symmetrie der Vorrichtung derart ausgebildet sein, dass die Y-Kondensatoren an mindestens zwei Seiten der Vorrichtung angeordnet sind, z.B. links und rechts des X-Kondensators und/oder mindestens eine Stromschiene der Vorrichtung symmetrisch ausgebildet ist. Die symmetrisch ausgebildete Vorrichtung kann z.B. als sogenanntes Schmetterlingskondensatormodul bezeichnet werden.

Die Erfindung wird anhand von Ausführungsbeispielen näher erläutert. Die Figuren zeigen:
- Fig. 1: eine schematische Darstellung einer Ausführungsform eines Stromwandlers mit einer Vorrichtung in einer räumlichen Ansicht,
- Fig. 2: eine schematische Darstellung einer weiteren Ausführungsform eines Stromwandlers mit einer Vorrichtung in einer räumlichen Ansicht,
- Fig. 3: eine schematische Darstellung einer weiteren Ausführungsform eines Stromwandlers mit einer Vorrichtung in einer räumlichen Ansicht und
- Fig. 4: eine schematische Darstellung einer weiteren Ausführungsform eines Stromwandlers mit einer Vorrichtung in einer Seitenansicht.

Nachfolgend bezeichnen gleiche Bezugszeichen Elemente mit gleichen technischen Merkmalen.

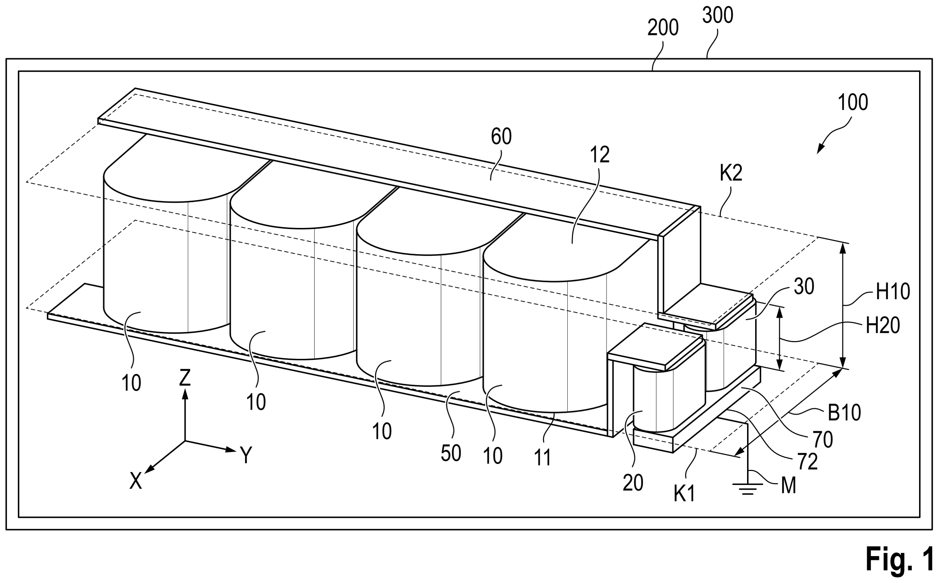

Fig. 1 zeigt eine schematische Darstellung einer Ausführungsform eines Stromwandlers 200 mit einer Vorrichtung 100 in einer ersten räumlichen Ansicht. Der Stromwandler 200 kann als Pulswechselrichter ausgebildet sein und z.B. in einem als PKW ausgebildeten Fahrzeug 300 verbaut sein, um Gleichstrom aus einer Traktionsbatterie (nicht dargestellt) in Wechselstrom für einen Elektromotor (nicht dargestellt) zu wandeln.

Die Vorrichtung 100 kann z.B. zwischen der Traktionsbatterie (nicht dargestellt) des Fahrzeugs 300 und einem Leistungsmodul (nicht dargestellt) des Stromwandlers 200 angeordnet sein.

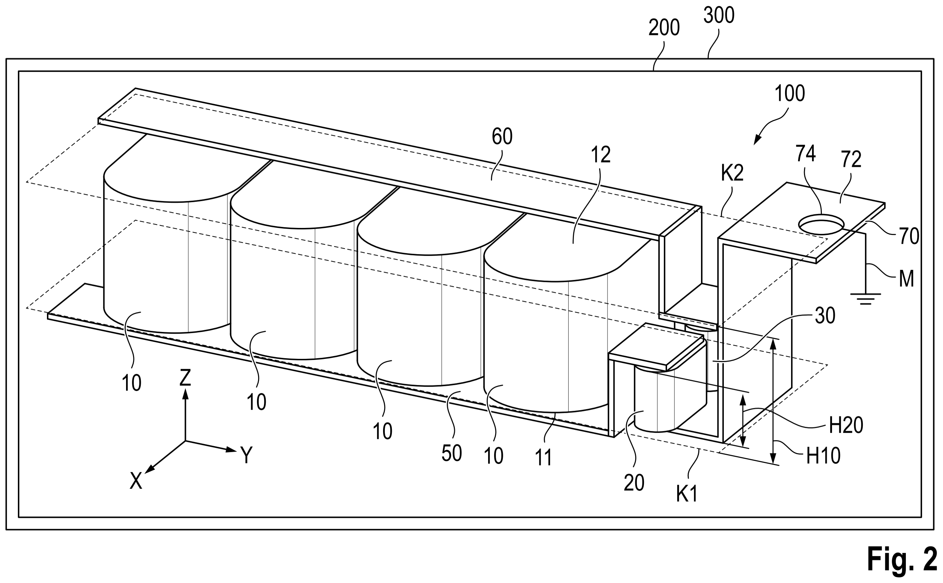

Zur einfacheren Erläuterung der Vorrichtung 100 ist in Fig. 1 ein kartesisches Koordinatensystem dargestellt. Das Koordinatensystem ist ebenfalls in den Fig. 2 bis Fig. 4 dargestellt. Eine Hochachse Z des Koordinatensystems ist z.B. entgegen einer Wirkrichtung der Schwerkraft ausgerichtet. Orthogonal zu der Hochachse Z sind jeweils eine Längsachse X und eine Querachse Y ausgerichtet. Die Längsachse X kann z.B. parallel zu einer Fahrtrichtung des Fahrzeugs 300 ausgerichtet sein. Die Querachse Y kann dementsprechend orthogonal zu der Fahrtrichtung des Fahrzeugs 300 ausgerichtet sein.

Die Vorrichtung 100 umfasst eine erste Stromschiene 50 und eine weitere Stromschiene 60. Die Stromschienen 50, 60 sind z.B. aus Kupfer hergestellt und können auch als Busbar bezeichnet werden. Die erste Stromschiene 50 kann z.B. an einen Minuspol (nicht dargestellt) der Traktionsbatterie des Fahrzeugs 300 angeschlossen sein und daher ein niedriges elektrisches Potential aufweisen. Die weitere Stromschiene 60 kann hingegen z.B. an einen Pluspol (nicht dargestellt) der Traktionsbatterie des Fahrzeugs 300 angeschlossen sein und daher ein hohes elektrisches Potential aufweisen.

Die Vorrichtung 100 umfasst ferner mehrere sogenannte X-Kondensatoren 10, die zwischen den Stromschienen 50, 60 entlang der Querachse Y angeordnet sind. Die X-Kondensatoren 10 sind z.B. als baugleiche Wickelkondensatoren ausgebildet. Die X-Kondensatoren 10 dienen in dem Stromwandler 200 als Zwischenkreiskondensatoren. Die X-Kondensatoren 10 weisen an einer Unterseite 11 und an einer Oberseite 12 jeweils einen Elektrodenanschluss auf (nicht dargestellt). Die Elektrodenanschlüsse der Unter- und Oberseite 11, 12 werden jeweils von einer der Stromschienen 50, 60 kontaktiert, um die X-Kondensatoren 10 parallelzuschalten. Selbstverständlich können z.B. entlang der Längsachse X noch weitere Reihen von X-Kondensatoren 10 zwischen den Stromschienen 50, 60 angeordnet sein, um die elektrische Kapazität der Vorrichtung 100 zu erhöhen.

Die Unterseite 11 der X-Kondensatoren 10 spannt hierbei eine erste Kontakteben K1 auf und die Oberseite 12 der X-Kondensatoren spannt eine weitere Kontaktebene K2 auf. Die erste Kontaktebene K1 und die weitere Kontaktebene K2 sind parallel zueinander und parallel zu einer durch die Längsachse X und die Querachse Y aufgespannten Ebene orientiert. Die Kontaktebenen K1, K2 sind entlang der Hochachse Z um eine Bauhöhe H10 der X-Kondensatoren 10 voneinander beabstandet.

Die Vorrichtung 100 umfasst ferner einen ersten Y-Kondensator 20 und einen weiteren Y-Kondensator 30. Die Y-Kondensatoren 20, 30 können ebenfalls als Wickelkondensatoren ausgebildet sein. Die erste Stromschiene 50 kontaktiert mit einem freien Ende den ersten Y-Kondensator 20. Die weitere Stromschiene 60 kontaktiert mit einem freien Ende den weiteren Y-Kondensator 30. Hierbei sind sowohl die X-Kondensatoren 10 als auch die Y-Kondensatoren 20, 30 in dem Bauraum zwischen der ersten Kontaktebene K1 und der weiteren Kontaktebene K2 angeordnet.

Die Y-Kondensatoren 20, 30 sind gemeinsam an ein als Kupferblech ausgebildetes Anschlusselement 70 angeschlossen, z.B. durch Löten. Das Anschlusselement 70 dient zur Anbindung an eine Masse M des Fahrzeugs 300. Insbesondere kann eine Unterseite des Anschlusselements 70 als Anschlussfläche 72 dienen, um das Anschlusselement 70 z.B. durch Punktschweißen an die Masse M anzubinden. Die Anschlussfläche 72 kann insbesondere außerhalb des Bauraums, d.h. unterhalb der weiteren Kontaktebene K2, angeordnet sein. Dies stellt eine Möglichkeit zum Anbinden des Anschlusselements 70 an die Masse M nach "unten" dar.

Da die Y-Kondensatoren 20, 30 jeweils eine geringere Bauhöhe H20 als die X-Kondensatoren 10 aufweisen, kann der entlang der Hochachse Z zur Verfügung stehende Bauraum zwischen den Kontaktebenen K1, K2 effizient zur Anordnung der Y-Kondensatoren 20, 30 genutzt werden. Der Bauraum kann zudem durch eine Baubreite der X-Kondensatoren in Richtung der Längsachse X begrenzt sein. Da die nebeneinander angeordneten Y-Kondensatoren 20, 30 eine gemeinsame Baubreite aufweisen, die der Baubreite B10 der X-Kondensatoren 10 entspricht, wird auch die Breite des Bauraums entlang der Längsachse X effizient genutzt.

Fig. 2 zeigt eine schematische Darstellung einer weiteren Ausführungsform eines Stromwandlers 200 mit einer Vorrichtung 100 aus der gleichen räumlichen Ansicht wie Fig. 1.

Im Gegensatz zu Fig. 1 ist in Fig. 2 das Anschlusselement 70 jedoch als Z-Blech ausgebildet. Hierbei ist eine Anschlussfläche 72 des Anschlusselements 70 oberhalb der ersten Kontaktebene K1 angeordnet. Dies stellt gegenüber der in Fig. 1 gezeigten Anbindung eine alternative Möglichkeit zum Anbinden des Anschlusselements 70 an eine Masse M nach "oben" dar.

Das Anschlusselement 70 weist zudem eine Aussparung 74 auf. Durch die Aussparung 74 kann z.B. eine Schraube (nicht dargestellt) geschraubt werden, um das Anschlusselement 70 an eine massegebundene Trägerhülse (nicht dargestellt) des Stromwandlers 200 anzubinden. Auch das in Fig. 1 gezeigte Anschlusselement 70 kann selbstverständlich eine solche Aussparung 74 aufweisen, auch wenn dies in Fig. 1 nicht dargestellt ist.

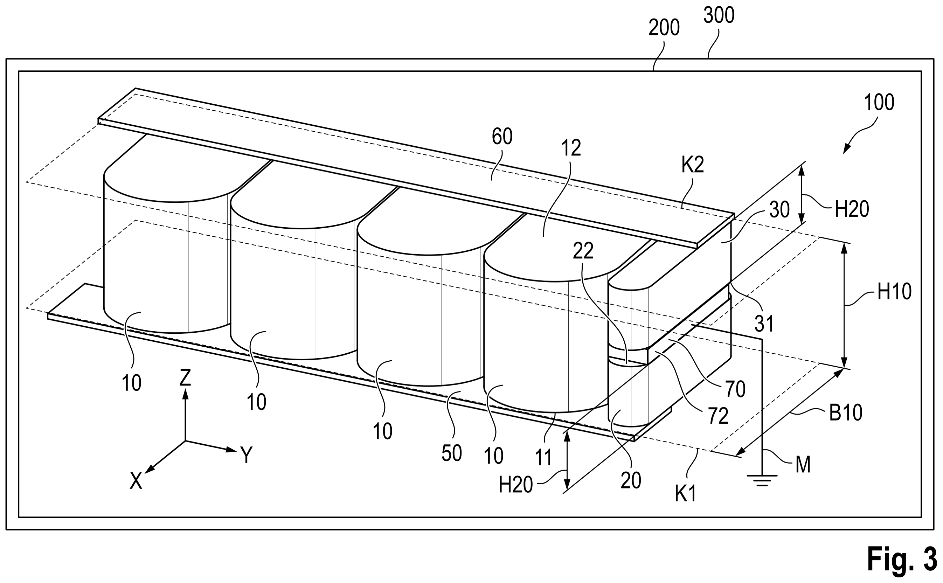

Fig. 3 zeigt eine schematische Darstellung einer weiteren Ausführungsform eines Stromwandlers 200 mit einer Vorrichtung 100 aus der gleichen räumlichen Ansicht wie Fig. 1 und Fig. 2.

Im Gegensatz zu Fig. 1 und Fig. 2 kontaktiert die erste Stromschiene 50 in der ersten Kontaktebene K1 sowohl die X-Kondensatoren 10 als auch den ersten Y-Kondensator 20. In analoger Weise kontaktiert die weitere Stromschiene 60 in der weiteren Kontaktebene K2 die X-Kondensatoren 10 und den weiteren Y-Kondensator 30. Hierdurch können die erste Stromschiene 50 und die weitere Stromschiene 60 entlang der Querachse Y gerade weitergeführt werden und müssen zur Kontaktierung der Y-Kondensatoren 20, 30 nicht gebogen werden. Dies vereinfacht die Herstellung der Vorrichtung 100.

Ferner sind in Fig. 3 der erste Y-Kondensator 20 und der weitere Y-Kondensator 30 entlang der Hochachse Z übereinander angeordnet. Hierdurch können die Y-Kondensatoren 20, 30 den Bauraum entlang der Baubreite B10 voll ausnutzen. Die Y-Kondensatoren 20, 30 sind insbesondere baugleich und weisen jeweils eine Bauhöhe H20 auf, die geringer ist als eine halbe Bauhöhe H10 der X-Kondensatoren 10.

Ein als Kupferblech ausgebildetes Anschlusselement 70 ist in einem Zwischenbereich zwischen den übereinander angeordneten Y-Kondensatoren 20, 30 angeordnet, um die Y-Kondensatoren 20, 30 zu kontaktieren. Das Anschlusselement 70 kann in dieser Konfiguration beispielsweise einen Elektrodenanschluss (nicht dargestellt) an einer Oberseite 22 des ersten Y-Kondensators 20 kontaktieren und ferner einen Elektrodenanschluss (nicht dargestellt) an einer Unterseite 31 des weiteren Y-Kondensators 30 kontaktieren. Der Anschluss an eine Masse M kann über eine seitliche Anschlussfläche 72 des Anschlusselements 70 erfolgen. Alternativ kann das Anschlusselement 70 auch aus den übereinander angeordneten Y-Kondensatoren 20, 30 herausragen, sodass eine Ober- oder Unterseite des Anschlusselements 70 als Anschlussfläche 72 fungieren kann. Ferner kann das Anschlusselement 70 selbstverständlich als Z-Blech oder ähnliches ausgebildet sein, um eine Anbindung an die Masse M außerhalb des Bauraums zu ermöglichen (vgl. Fig. 2).

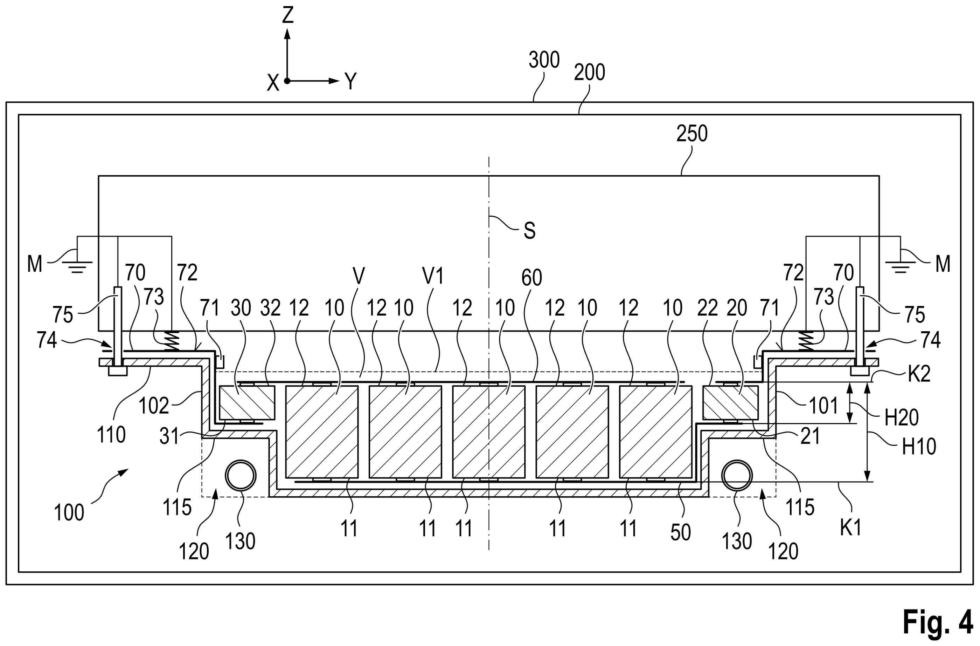

Fig. 4 zeigt eine schematische Darstellung einer weiteren Ausführungsform eines Stromwandlers 200 mit einer Vorrichtung 100 in einer Seitenansicht. Die Seitenansicht zeigt die Vorrichtung 100 in einem Querschnitt in einer durch die Querachse Y und die Hochachse Z aufgespannten Ebene. Der Stromwandler 200 umfasst zudem ein Leistungsmodul 250, wobei die Vorrichtung 100 lösbar mit dem Leistungsmodul 250 verbunden ist.

Die Vorrichtung 100 weist ein aus Spritzguss hergestelltes Gehäuse 110 auf. In dem Gehäuse 110 sind fünf X-Kondensatoren 10 nebeneinander entlang der Querachse Y angeordnet. Auf einer rechtsseitigen Stufe 115 des Gehäuses 110 ist ein erster Y-Kondensator 20 angeordnet. Auf einer gegenüberliegenden Stufe 115 ist ein weiterer Y-Kondensator 30 des Gehäuses 110 angerordnet. Somit ist Vorrichtung 100 hinsichtlich der Anordnung der Kondensatoren 10, 20 30 symmetrisch ausgebildet. Dies ist in Fig. 4 durch die Symmetrieachse S gekennzeichnet.

Die fünf X-Kondensatoren 10 sind über eine erste Stromschiene 50 und eine weitere Stromschiene 60 parallelgeschaltet. Die Stromschienen 50, 60 können netz- bzw. quellenseitig mit einer Traktionsbatterie des Fahrzeugs 300 (nicht dargestellt) verbunden sein. lastseitig können die Stromschienen 50, 60 mit dem Leistungsmodul 250 verbunden sein. Diese elektrischen Verbindungen (nicht dargestellt) können z.B. entlang der Längsachse X erfolgen.

Der erste Y-Kondensator 20 ist an einer Unterseite 21 mit der ersten Stromschiene 50 verbunden. Zudem ist der erste Y-Kondensator 20 an einer Oberseite 22 mit einem Anschlusselement 70 verbunden. Der weitere Y-Kondensator 30 ist hingegen an einer Oberseite 32 mit der weiteren Stromschiene 60 verbunden und an einer Unterseite 31 mit einem weiteren Anschlusselement 70 verbunden.

Die Y-Kondensatoren 20, 30 sind jeweils über die Anschlusselemente 70 an eine Masse M angebunden, sodass hochfrequente elektrische Störungen, die im Betrieb des Stromwandlers 200 auftreten können, verringert sind. Um die elektrischen Störungen noch effektiver verringern zu können, ist auf jedem Anschlusselement 70 ein als Dickschichtwiderstand ausgebildeter elektrischer Widerstand 71 zwischen dem Anschluss an den jeweiligen Y-Kondensator 20, 30 und der Masse M montiert.

Der Vollständigkeit halber sei erwähnt, dass auf der rechtsseitigen Stufe 115 entlang der Längsachse X "vor" oder "hinter" dem ersten Y-Kondensator 20 ein weiterer Y-Kondensator 30 angeordnet ist, der ebenfalls an das rechtsseitige Anschlusselement 70 angeschlossen ist. Der weitere Y-Kondensator 30 ist jedoch im Gegensatz zu dem ersten Y-Kondensator 20 nicht mit der ersten Stromschiene 50, sondern mit der weiteren Stromschiene 60 elektrisch verbunden (vgl. Fig. 1 bis Fig. 3). Analoges gilt für einen ersten Y-Kondensator 20, der auf der linkseitigen Stufe 115 "vor" oder "hinter dem weiteren Y-Kondensator 30 angeordnet ist, mutatis mutandis. Die Y-Kondensatoren 20, 30 sind auf der jeweiligen Stufe 115 somit alternierend gepolt. Dies kann parasitäre Effekte reduzieren da sich die um die Y-Kondensatoren 20, 30 entstehenden Magnetfelder aufgrund der unmittelbaren Nähe zueinander gegenseitig kompensieren können.

Die Kondensatoren 10, 20, 30 sowie die Stromschienen 50, 60 der Vorrichtung 100 sind vollständig in einem mit Epoxidharz gefüllten Vergussvolumen V vergossen, um die Komponenten vor Beschädigungen zu schützen. Eine Oberseite V1 des Vergussvolumens V ist in Fig. 4 durch eine gestrichelte Linie gekennzeichnet.

Die links- und rechtsseitigen Anschlusselemente 70 weisen jeweils eine Anschlussfläche 72 auf, die außerhalb des Vergussvolumens V angeordnet ist. Die Anschlussfläche 72 ragt somit aus dem Vergussvolumen V heraus. Hierdurch können die linksseitigen und rechtsseitigen Anschlussflächen 72 während einer Montage der Vorrichtung 100 an das Leistungsmodul 250 jeweils mit einer als Spiralfeder ausgebildeten Kontaktfeder 73 kontaktiert werden, um das jeweilige Anschlusselement 70 an die Masse M des Leistungsmoduls 250 anzubinden. Die Kontaktierung mittels der Kontaktfedern 73 ermöglicht eine werkzeugfreie und zerstörungsfrei zu lösende Anbindung des Anschlusselements 70 an die Masse M. Dies vereinfacht eine Wartung der Vorrichtung 100.

Die Vorrichtung 100 ist z.B. mittels zwei Schrauben 75 an dem Leistungsmodul 250 lösbar befestigt. Die Schrauben 75 sind jeweils durch eine Aussparung 74 in den Anschlusselementen 70 hindurchgeführt, sodass auch über die Schrauben 75 eine Anbindung an die Masse M des Leistungsmoduls 250 möglich ist. Zur Verbesserung der elektrischen Verbindung zwischen dem jeweiligen Anschlusselement 70 und der Schraube 75 kann eine metallische Unterlegschreibe (nicht dargestellt) zwischen der Schraube 75 und dem Anschlusselement 70 angeordnet sein. Durch die Kontaktierung mittels der Kontaktfedern 73 und die Befestigung mittels der Schrauben 75 ist die Vorrichtung 100 mit einer besonders hohen Kontaktsteifigkeit an das Leistungsmodul 250 angebunden.

Ferner ist in Fig. 4 erkennbar, dass der Bauraum, der rechtsseitig und linksseitig der X-Kondensatoren 10 zur Anordnung der Y-Kondensatoren 20, 30 zwischen der ersten Kontaktebene K1 und der weiteren Kontaktebene K2 zur Verfügung steht, durch folgende Komponenten begrenzt wird. Rechtsseitig wird der Bauraum durch eine rechte Seitenwand 101 des Gehäuses 110 begrenzt. Linksseitig wird der Bauraum durch eine linke Seitenwand 102 des Gehäuses 110 begrenzt. Ferner begrenzt die jeweilige Stufe 115 den Bauraum entlang der Hochachse Z.

Abschließend sei erwähnt, dass unterhalb der Stufen 115 jeweils ein Kühlelement 130 angeordnet ist, um die Vorrichtung 100 zu kühlen und einen Freiraum 120 unterhalb der Stufen 115 effizient zu nutzen. Das Kühlelement 130 kann z.B. ein Kühlschlauch eines Kühlkreislaufs (nicht dargestellt) der Vorrichtung 100 sein. Selbstverständlich kann auch das Leistungsmodul 250 ein Kühlelement (nicht dargestellt) aufweisen, welches z.B. zwischen den Halbleiterelementen (nicht dargestellt) des Leistungsmoduls 250 und der Vorrichtung 100 angeordnet ist. Auf diese Weise kann die Vorrichtung 100 von "oben" und "unten" gekühlt werden.

### Bezugszeichenliste

- 10: X-Kondensator
- 11: Unterseite X-Kondensator
- 12: Oberseite X-Kondensator
- 20: erster Y-Kondensator
- 21: Unterseite erster Y-Kondensator
- 22: Oberseite erster Y-Kondensator
- 30: weiterer Y-Kondensator
- 31: Unterseite weiterer Y-Kondensator
- 32: Oberseite weiterer Y-Kondensator
- 50: erste Stromschiene
- 60: weitere Stromschiene
- 70: Anschlusselement
- 71: elektrischer Widerstand
- 72: Anschlussfläche
- 73: Kontaktfeder
- 74: Aussparung
- 75: Schraube
- 100: Vorrichtung
- 101: rechte Seite
- 102: linke Seite
- 110: Gehäuse
- 115: Stufe
- 120: Freiraum
- 130: Kühlelement
- 200: Stromwandler
- 250: Leistungsmodul
- 300: Fahrzeug
- B10: Baubreite X-Kondensator
- H10: Bauhöhe X-Kondensator
- H20: Bauhöhe erster oder weiterer Y-Kondensator
- K1: erste Kontaktebene
- K2: weitere Kontaktebene
- M: Masse
- S: Symmetrieachse
- V: Vergussvolumen
- V1: Oberseite des Vergussvolumens
- X: Längsachse
- Y: Querachse
- Z: Hochachse

## Patentansprüche

1. Vorrichtung (100) für einen Stromwandler (200), umfassend:
- mindestens einen X-Kondensator (10),
- mindestens einen ersten Y-Kondensator (20),
- mindestens einen weiteren Y-Kondensator (30),
wobei mindestens eine erste Stromschiene (50) den mindestens einen X-Kondensator (10) und den mindestens einen ersten Y-Kondensator (20) kontaktiert, wobei mindestens eine weitere Stromschiene (60) den mindestens einen X-Kondensator (10) und den mindestens einen weiteren Y-Kondensator (30) kontaktiert,
wobei die erste Stromschiene (50) den mindestens einen X-Kondensator (10) in einer ersten Kontaktebene (K1) kontaktiert, wobei die weitere Stromschiene (60) den mindestens einen X-Kondensator (10) in einer weiteren Kontaktebene (K2) kontaktiert,
wobei sowohl der mindestens eine X-Kondensator (10) als auch die Y-Kondensatoren (20, 30) in einem Bauraum zwischen der ersten Kontaktebene (K1) und der weiteren Kontaktebene (K2) angeordnet sind, wobei der mindestens eine erste Y-Kondensator (20) und der mindestens eine weitere Y-Kondensator (30) gemeinsam an ein Anschlusselement (70) angeschlossen sind, wobei das Anschlusselement (70) zur Anbindung an eine Masse (M) ausgebildet ist.

2. Vorrichtung (100) nach Anspruch 1, **dadurch gekennzeichnet, dass** der mindestens eine erste Y-Kondensator (20) und der mindestens eine weitere Y-Kondensator (30) gemeinsam in einer Stufe (115) eines Gehäuses (110) der Vorrichtung (100) angeordnet sind.

3. Vorrichtung (100) nach einem der vorangegangen Ansprüche, **dadurch gekennzeichnet, dass** die erste Stromschiene (50) den mindestens einen X-Kondensator (10) und den mindestens einen ersten Y-Kondensator (20) in der ersten Kontaktebene (K1) kontaktiert und/oder die weitere Stromschiene (60) kontaktiert den mindestens einen X-Kondensator (10) und den mindestens einen weiteren Y-Kondensator (30) in der weiteren Kontaktebene (K2).

4. Vorrichtung (100) nach einem der vorangegangen Ansprüche, **dadurch gekennzeichnet, dass** das Anschlusselement (70) mittels mindestens einer Kontaktfeder (73) an die Masse (M) angebunden ist.

5. Vorrichtung (100) nach einem der vorangegangen Ansprüche, **dadurch gekennzeichnet, dass** der mindestens eine erste Y-Kondensator (20) und der mindestens eine weitere Y-Kondensator (30) in dem Bauraum übereinander angeordnet sind.

6. Vorrichtung (100) nach einem der vorangegangen Ansprüche, **dadurch gekennzeichnet, dass** das gemeinsame Anschlusselement (70) mindestens einen elektrischen Widerstand (71) umfasst.

7. Vorrichtung (100) nach einem der vorangegangen Ansprüche, **dadurch gekennzeichnet, dass** das Anschlusselement (70) mindestens eine Anschlussfläche (72) zur Kontaktierung der Masse (M) aufweist, wobei die mindestens eine Anschlussfläche (72) außerhalb eines Vergussvolumens (V) der Vorrichtung (100) angeordnet ist.

8. Vorrichtung (100) nach einem der vorangegangenen Ansprüche, **dadurch gekennzeichnet, dass** die Vorrichtung (100) symmetrisch ausgebildet ist.

9. Stromwandler (200), umfassend mindestens eine Vorrichtung (100) nach einem der Ansprüche 1 bis 8.

10. Fahrzeug (300), umfassend mindestens eine Vorrichtung (100) nach einem der Ansprüche 1 bis 8.
